# EUROPÄISCHE PATENTSCHRIFT

(11) **EP 4 204 235 B1**
(45) Veröffentlichungstag und Bekanntmachung des Hinweises auf die Patenterteilung: **18.02.2026**
(21) Anmeldenummer: 21752541.9
(22) Anmeldetag: 30.07.2021
(51) Int. Cl.: B41N 1/24, B41F 15/34, H05K 3/12, B41F 15/36, B41F 15/08, B41F 15/38, H10F 77/20

(54) **DRUCKFORM ZUR HERSTELLUNG EINER STRUKTUR EINES ELEKTRONISCHEN BAUELEMENTES, INSBESONDERE EINER PHOTOVOLTAISCHEN SOLARZELLE UND VERFAHREN ZUR HERSTELLUNG SOLCH EINER DRUCKFORM**
PRINTING STENCIL FOR PRODUCING A STRUCTURE OF AN ELECTRONIC COMPONENT, IN PARTICULAR OF A PHOTOVOLTAIC SOLAR CELL, AND METHOD FOR PRODUCING A PRINTING STENCIL OF THIS TYPE
FORME IMPRIMANTE POUR LA FABRICATION D'UNE STRUCTURE D'UN COMPOSANT ÉLECTRONIQUE, EN PARTICULIER D'UNE CELLULE SOLAIRE PHOTOVOLTAÏQUE, ET PROCÉDÉ DE FABRICATION D'UNE TELLE FORME IMPRIMANTE

(30) Priorität: 25.08.2020 DE 102020122181
(43) Veröffentlichungstag der Anmeldung: 05.07.2023
(73) Patentinhaber: Fraunhofer-Gesellschaft zur Förderung der angewandten Forschung e.V., 80686 München (DE)
(72) Erfinder: TEPNER, Sebastian, 79110 Freiburg (DE); SINGLER, Marius, 79110 Freiburg (DE); LORENZ, Andreas, 79110 Freiburg (DE); NEY, Linda, 79110 Freiburg (DE); LINSE, Michael, 79110 Freiburg (DE); CLEMENT, Florian, 79110 Freiburg (DE)
(74) Vertreter: LBP Lemcke, Brommer & Partner Patentanwälte mbB
(86) Internationale Anmeldenummer: PCT/EP2021/071424
(87) Internationale Veröffentlichungsnummer: WO 2022/043003

(56) Entgegenhaltungen:
- EP-A1- 3 000 612
- DE-U1- 29 708 329
- JP-A- 2017 091 741
- JP-A- H10 315 647
- US-A1- 2015 352 830
- US-A1- 2017 001 430

## Beschreibung

Die Erfindung betrifft eine Druckform zur Herstellung einer Struktur eines elektronischen Bauelementes, insbesondere einer photovoltaischen Solarzelle gemäß Oberbegriff des Anspruchs 1 sowie ein Verfahren zur Herstellung solch einer Druckform gemäß Oberbegriff des Anspruchs 7. Die Erfindung betrifft weiterhin ein Verfahren zum Aufbringen einer Druckpaste auf die Oberfläche eines elektronischen Bauelementes, insbesondere einer photovoltaischen Solarzelle mittels einer Druckform gemäß Oberbegriff des Anspruchs 11.

Bei Herstellung von elektronischen Bauelementen wie beispielsweise Halbleiterbauelementen oder Leiterplatten, insbesondere jedoch bei der Herstellung von photovoltaischen Solarzellen ist bei vielen Herstellungsverfahren das Aufbringen einer Druckpaste in einer vorgegebenen, typischerweise linienförmigen, insbesondere geradlinigen Struktur notwendig. Die Druckpaste kann metallische Partikel zur Ausbildung einer metallischen Leitungs- und/oder Kontaktierungsstruktur des Bauelementes aufweisen. Zusätzlich oder alternativ kann die Druckpaste auch Stoffe zur Behandlung des Halbleiters, insbesondere Dotierelemente zum Ausbilden von Dotierregionen im Halbleitermaterial des Bauelementes aufweisen.

Es ist bekannt, mittels Siebdruck eine Druckpaste auf einen oder mehrere lokale Bereiche einer Oberfläche des Bauelementes aufzubringen, um die vorgenannte Struktur auszubilden. Hierbei wird eine Druckform verwendet, welche einen Siebrahmen und ein Sieb umfasst. Dass Sieb ist als flächenförmiges Textil ausgebildet. An dem Sieb ist eine Schablone angeordnet, welche einen für die Druckpaste durchlässigen Druckbereich durch Öffnungen bzw. von der Schablone ausgesparte Bereiche definiert sowie einen für die Druckpaste undurchlässigen Sperrbereich definiert, welcher durch die Schablone bedeckt ist. Das als flächenförmiges Textil ausgebildete Sieb weist mehrere längliche Siebelemente auf, welche typischerweise parallel und zueinander beabstandet verlaufen bzw. senkrecht zueinander verlaufen.

Zum Aufbringen der Druckpaste auf die Oberfläche des elektronischen Bauelementes wird die Druckpaste zumindest im Druckbereich der Druckform aufgebracht. Das Sieb verhindert, dass die Druckpaste unmittelbar bei Aufbringen auf die Druckform diese durchdringt. Erst unter Aufwendung einer zusätzlichen Kraft, typischerweise mittels einer Rakel, wird die Druckpaste im Druckbereich durch die Druckform hindurch und somit insbesondere durch das Sieb hindurch auf die Oberfläche des Bauelementes aufgebracht.

Es besteht zunehmend die Anforderung, linienartige Strukturen mit zunehmend geringerer Breite auszubilden. Die durch den Druckbereich definierten Kanäle zur Ausbildung der linienartigen Strukturen müssen somit gemäß dieser Anforderung eine entsprechend geringe Breite aufweisen. Nachteilig an vorbekannten Druckformen ist, dass durch den Aufbau der Druckform an sich eine minimale Kanalbreite nicht unterschritten werden kann, da andernfalls unregelmäßige oder auch unzusammenhängende linienartige Strukturen der Druckpaste aufgebracht werden.

In JP2017091741A ist ein Verfahren zur Erstellung feiner Membran-Linienmuster auf einem Substrat mittels Siebdruckes offenbart. Dabei wird zunächst eine Resistschicht mit inversen Mustern aufgetragen. Anschließend wird mittels einer zweiten Siebdruckplatte die Membran in den nicht bedeckten Bereichen aufgetragen. Nachfolgend wird das gewünschte Membran-Linienmuster durch Entfernen der Resistschicht gebildet.

In US20170001430A1 wird eine Druckschablone mit gleichmäßiger Dicke für präzisen Druck und einer rauen Oberfläche für bessere Trennung vom Druckmedium vorgeschlagen sowie ein Herstellungsverfahren vorgeschlagen. Das Verfahren beinhaltet die Vorbereitung eines Substrats mit einem Druckmuster und einer organischen Oberfläche, gefolgt von Trockenätzung auf der Druckoberfläche.

In US2015/352830A1 ist eine Siebdruckplatte offenbart, welche aus mindestens zwei gewebten Fasern besteht, darunter Polymerfasern oder anorganische Fasern. Mindestens eine dieser Fasern ist löslich, z.B. in einem organischen Lösungsmittel. Die Siebdruckplatte weist hierbei ein sich unterscheidendes Maschenmuster auf, welches sich durch das Auflösen der gewebten Faser(n) ergibt.

In JPH10315647A ist ebenfalls eine Siebdruckplatte für das Drucken feiner Muster auf dickem Material vorgeschlagen. Die Siebdruckplatte weist hierbei mindestens einem Rahmengewebe und eine Schablone auf, wobei das Gewebe aus zwei oder mehr Maschen besteht. Die Maschen sind hierbei derart angeordnet, dass die Zwischenräume von mindestens zwei Maschen in einem symmetrischen Winkel zur Druckrichtung übereinander liegen, und die beiden Maschen werden durch eine Folie oder eine Beschichtung fixiert.

In DE29708329U1 wir eine Siebdruckschablone offenbart, welche die Flexibilität und Anpassungsfähigkeit eines Siebes mit der Stabilität von offenen Durchbrüchen einer Metallschablone kombiniert. Hierbei wird eine Schablone, die aus zwei verschiedenen Materialien für Ober- und Unterseite besteht, vorgeschlagen.

In EP3000612A1 ist eine Struktur für den Siebdruck vorgeschlagen, welche die Benetzbarkeit einer gerakelten Oberfläche erhöht und eine wasser /ölabweisende Schicht bildet.

Der vorliegenden Erfindung liegt somit die Aufgabe zugrunde, eine Druckform zur Verfügung zu stellen, welche die Ausbildung von linienartigen Strukturen aus Druckpaste mit geringer Breite ermöglicht.

Gelöst ist diese Aufgabe durch eine Druckform gemäß Anspruch 1, ein Verfahren zur Herstellung einer Druckform gemäß Anspruch 7 und ein Verfahren zum Aufbringen einer Druckpaste gemäß Anspruch 11. Vorteilhafte Ausgestaltungen finden sich in den abhängigen Ansprüchen.

Die erfindungsgemäße Druckform zur Herstellung einer Struktur eines elektronischen Bauelementes, insbesondere einer photovoltaischen Solarzelle, weist einen Siebrahmen und ein als flächenförmiges Textil ausgebildetes Sieb mit einer Vielzahl von länglichen Siebelementen auf. Das Sieb ist in dem Siebrahmen angeordnet, bevorzugt unter Aufbringung einer Zugspannung. Das Sieb weist zumindest einen für die Druckpaste durchlässigen Druckbereich und zumindest einen für die Druckpaste undurchlässigen Sperrbereich auf.

Wesentlich ist, dass die länglichen Siebelemente als Kohlenstoffnanoröhre ausgebildet sind und dass das Textil mit einer Zugspannung im Bereich von 6001 N/mm² (Megapascal) bis 63000 N/mm² (Megapascal) in dem Siebrahmen angeordnet ist.

Der Erfindung liegt die Erkenntnis der Anmelderin zugrunde, dass die Zugspannung, mit welcher die länglichen Siebelemente in dem Siebrahmen angeordnet sind, ein wesentlicher Parameter für die minimal mögliche Kanalbreite eines Druckbereichs der Druckform ist.

Wird daher für die länglichen Siebelemente ein Material verwendet, welches eine besonders hohe Zugspannung ermöglicht, so können linienförmige Elemente mit besonders geringer Breite ausgebildet werden. Durch Experimente und Berechnungen ist es der Anmelderin gelungen, die Anzahl an Siebelementen pro Strecke (typischerweise angegeben in Siebelemente pro Inch) sowie den Durchmesser der Siebelemente zu verringern, indem das Material, aus welchem die Siebelemente hergestellt werden dahingehend angepasst wird, dass eine materialspezifisch hohe Zugspannung vorliegt.

Untersuchungen der Anmelderin zeigen, dass insbesondere eine maximale Gewebespannung des als flächenförmiges textilausgebildeten Siebs und damit auch die Druckqualität aufgebrachter Strukturen mit geringer Kanalbreite erhöht wird, indem die länglichen Siebelemente als Kohlenstoffnanoröhre ausgebildet sind.

Bei Ausbildung der länglichen Siebelemente als Kohlenstoffnanoröhren können Zugspannungen von 63.000 N/mm² (Megapascal) erreicht werden.

Untersuchungen der Anmelderin zeigen, dass die Erhöhung der Zugspannung durch die Materialwahl der Siebelemente bei der erfindungsgemäßen Druckform eine erhebliche Verringerung des Durchmessers der Siebelemente ermöglicht.

Dies ist insofern überraschend, da der Durchmesser der Siebelemente ein Parameter ist, dessen Erhöhung größere Zugspannungen ermöglicht. Bei vorbekannten Druckformen wurde eine gewünschte Erhöhung der Gewebespannung, d. h. der Zugspannung der länglichen Siebelemente dadurch erzielt, dass der Durchmesser der Siebelemente erhöht wurde. Die Materialwahl bei der erfindungsgemäßen Druckform ermöglicht hingegen die Erzielung hoher Gewebespannungen bei dennoch geringen Durchmessern.

Erfindungsgemäß werden die Druckform mit folgenden Zugspannungen und Durchmessern der länglichen Siebelemente ausgebildet:

| Material der länglichen Siebelemente | Durchmesser der Siebelemente | Zugspannung |
|---|---|---|
| Kohlenstoffnanoröhren | 50 nm bis 2 µm | 6001 N/mm² (Megapascal) bis 63000 N/mm² (Megapascal) |

Durch die vorgenannten bevorzugten Bereiche für die genannten Parameter werden geringe Kanalbreiten und somit geringe Breiten der mittels der Druckpaste ausgebildeten linienartigen Strukturen ermöglicht.

Untersuchungen der Anmelderin zeigen, dass bei der Ausgestaltung der länglichen Siebelemente aus Kohlenstoffnanoröhren bevorzugt im Bereich 1968 Siebelemente pro m (50 Siebelemente pro Inch) bis 393700 Siebelemente pro m (10.000 Siebelemente pro Inch) angeordnet werden.

Insbesondere ist es vorteilhaft, bei Ausbildung der länglichen Siebelemente aus Kohlenstoffnanoröhren zwischen 2755 Siebelemente pro m (70 Siebelemente pro Inch) und 79724 Siebelemente pro m (2025 Siebelemente pro Inch) anzuordnen.

Die vorgenannten Dichten für die Siebelemente werden bevorzugt zumindest im Druckbereich der Druckform ausgebildet, weiter bevorzugt im Druckbereich und Sperrbereich.

Wie zuvor beschrieben, ist die erfindungsgemäße Druckform insbesondere zur Herstellung von länglichen, linienförmigen Strukturen aus Druckpaste geeignet. Vorteilhafterweise ist der Druckbereich daher zumindest teilweise als eine längliche Kanalöffnung, insbesondere eine linienförmige Kanalöffnung, bevorzugt eine geradlinige Kanalöffnung ausgebildet, bevorzugt mit einer Längserstreckung und einer Kanalbreite (b). Die Kanalbreite (b) ist bevorzugt kleiner als 40 µm, vorzugsweise kleiner als 20 µm, insbesondere bevorzugt kleiner als 10 µm.

Das als flächenförmiges Textil ausgebildete Sieb weist bevorzugt zumindest eine erste Gruppe von länglichen Siebelementen auf, wobei die länglichen Siebelemente dieser Gruppe parallel zueinander und weiter bevorzugt äquidistant zueinander angeordnet sind. Vorzugsweise ist bei Vorsehen mindestens einer geradlinigen Kanalöffnung im Druckbereich die Kanalöffnung in einem Winkel ungleich 0° gegenüber der Längsachse der Kanalöffnung angeordnet. Insbesondere ist es vorteilhaft, einen Winkel und eine maximale Kanalbreite vorzusehen, wie in DE 10 2019 122 126.9 beschrieben. Insbesondere ist es vorteilhaft, dass der zuvor beschriebene zumindest eine geradlinige Kanal des Druckbereichs einen Winkel mit einem Siebelement des Druckbereichs mit einer Toleranz von +/- 0,1° einschließt, wobei der Winkel aus der Gruppe 11,31°, 14,04°, 18,44°, 26,57°, 45°, 33,69°, insbesondere 11,31°, 14,04°, 18,44°, 26,57°, 33,69° ausgewählt ist.

Hierdurch lässt sich eine vorteilhafte Verringerung der Knoten von Siebelementen innerhalb der Kanalöffnung erzielen, wie aus DE 10 2019 122 126.9 bekannt.

Vorteilhafterweise weist das als flächenförmiges Textil ausgebildete Sieb der Druckform zumindest eine zweite Gruppe von länglichen Siebelementen auf, wobei die länglichen Siebelemente der zweiten Gruppe parallel zueinander und bevorzugt äquidistant angeordnet sind. Insbesondere ist es vorteilhaft, dass die Siebelemente der ersten und der zweiten Gruppe einen Winkel im Bereich von 30° bis 150°, bevorzugt 60° bis 120°, insbesondere bevorzugt 85° bis 95°, bevorzugt 90° einschließen.

Insbesondere ist es vorteilhaft, dass die länglichen Siebelemente der Druckform vollständig der vorgenannten ersten und zweiten Gruppe zugeordnet sind.

Die länglichen Siebelemente sind somit bevorzugt paarweise parallel oder senkrecht zueinander angeordnet.

Untersuchungen der Anmelderin haben ergeben, dass bevorzugt in dem Druckbereich ein Flächenverhältnis SUI, welches sich aus dem Verhältnis der freien Fläche im Druckbereichs zu der von den länglichen Siebelementen im Druckbereich abgedeckten Fläche ergibt, größer als 0,5, bevor vorzugsweise größer als 0,75, insbesondere größer als 1 ist. Hierdurch wird ein vorteilhaftes Öffnungsverhältnis erzielt, um Druckpaste mit einem vorteilhaft geringen Druck, insbesondere mittels einer Rakel, durch das Sieb hindurch auf die Oberfläche des Bauelementes aufzubringen.

Wie vorangehend beschrieben, weist die erfindungsgemäße Druckform eine Vielzahl von länglichen Siebelementen auf. Es liegt im Rahmen der Erfindung, dass die Siebelemente miteinander verbunden sind und insbesondere aus einem oder mehreren länglichen, biegeschlaffen Siebelement-Grundelement mittels Umlenkung im Bereich des Siebrahmens ausgebildet werden.

Die eingangs genannte Aufgabe ist weiterhin durch ein Verfahren zur Herstellung einer Druckform mit einem Siebrahmen und einem flächigen Sieb mit einer Vielzahl von länglichen Siebelementen und zumindest einem für Druck passte durchlässigen Druckbereich und einen für Druckpaste undurchlässigen Sperrbereich gelöst.

Wesentlich ist, dass die länglichen Siebelemente in Form von Kohlenstoffnanoröhren ausgebildet werden und in einem Bindungsschritt zu einem biegeschlaffen, flächigen Textil, insbesondere einem Gewebe oder Gelege gefügt werden. Das flächige Textil wird in einem Spannschritt mit dem Randbereich an dem Siebrahmen angeordnet und mit dem Siebrahmen verbunden, bevorzugt unter Aufbringung einer Zugspannung.

Hierdurch ergeben sich die zu der erfindungsgemäßen Druckform genannten Vorteile. Wesentlich ist, dass das Textil mit einer Zugspannung im Bereich von 6001 N/mm² (Megapascal) bis 63000 N/mm² (Megapascal) in dem Siebrahmen angeordnet wird.

Die Zugspannung des Textils wird bevorzugt erzielt, indem die länglichen Siebelemente unter Zugspannung insbesondere in einem zur Herstellung verwendeten Siebrahmen angeordnet werden und anschließend fixiert werden, insbesondere bevorzugt mittels des Materials, mittels dessen der Sperrbereich ausgebildet wird. Bei dieser vorteilhaften Ausführungsform muss somit die Zugspannung des Textils nicht zwingend durch ein Einspannen in einem Rahmen wie beispielsweise dem Siebrahmen der Druckform erfolgen. Durch die Fixierung mittels des Fixiermaterials, insbesondere des Materials einer Schablone, welche den Sperrbereich definiert, kann die Zugspannung des Textils auch ohne äußeren Rahmen fixiert werden.

In einer alternativen bevorzugten Ausgestaltung wird die Zugspannung des Textils wird erzielt, indem das Sieb unter Zugspannung in dem Rahmen angeordnet und an dem Rahmen fixiert wird.

In einer weiteren vorteilhaften Ausgestaltung erfolgt das Ausbilden der Zugspannung des Textils durch eine Kombination des Einspannens des Textils in dem Siebrahmen der Druckform und einem Fixieren des Textils mit einem Material, bevorzugt mittels des Materials, mittels dessen der Sperrbereich ausgebildet wird, insbesondere des Materials einer Schablone, welche den Sperrbereich definiert.

Vorteilhafterweise erfolgt in einem Beschichtungsschritt eine für Druckpaste undurchlässige Sperrschicht, vorzugsweise eine Ethylen-Propylen-Dien-Kautschuk enthaltende Sperrschicht, welche an dem Sieb angeordnet wird. In dem Strukturierungsschritt wird bevorzugt in der Sperrschicht eine Öffnung für den Druckbereich ausgestaltet, insbesondere bevorzugt eine längliche Kanalöffnung. Die Öffnung wird bevorzugt mittels eines Lasers ausgebildet, insbesondere mittels Laserablation. Dies ermöglicht eine präzise und zugleich kostengünstige Ausbildung des oder der Druckbereiche.

Diese Öffnung bildet somit einen für die Druckpaste durchlässigen Druckbereich aus.

Vorteilhafterweise wird in der Druckschablone zumindest eine Kanalöffnung ausgebildet, welche linienartig, insbesondere bevorzugt geradlinig ausgebildet ist und eine Kanalbreite aufweist, welche kleiner 40 µm ist, bevorzugt kleiner 20 µm ist, höchstvorzugsweise kleiner 10 µm ist.

Vorteilhafterweise wird in einem Öffnungsschritt ein Schablonenrohling, insbesondere ein dünnwandiges Blech, mittels eines Lasers zu einer Druckschablone verarbeitet, wobei im Schablonenrohling eine längliche Kanalöffnung, bevorzugt eine geradlinige Kanalöffnung ausgeschaltet wird, und in einem Montageschritt wird die Druckschablone an dem Sieb angeordnet.

In dieser vorteilhaften Ausführungsform erfolgt somit die Definition des Druckbereiches in der Druckschablone, bevor die Druckschablone an dem Sieb angeordnet wird. Hierdurch wird eine Beschädigung des Siebs bei Ausbilden des oder der Druckbereiche vermieden.

Die eingangs genannte Aufgabe ist weiterhin durch ein Verfahren zum Aufbringen einer Druckpaste auf die Oberfläche eines elektronischen Bauelementes, insbesondere einer photovoltaischen Solarzelle mittels einer Druckform gelöst, wobei mittels einer Rakel Druckpaste durch die Druckform auf ein Substrat des elektronischen Bauelementes aufgebracht wird. Wesentlich ist, dass eine erfindungsgemäße Druckform, insbesondere eine bevorzugte Ausführungsform hiervon, verwendet wird.

Hierdurch lassen sich in vorteilhafter Weise linienartige Strukturen von Druckpaste mit geringer Breite auf eine Oberfläche des elektronischen Bauelementes aufbringen.

Weitere vorteilhafte Merkmale und bevorzugte Ausführungsformen werden im Folgenden anhand von Ausführungsbeispielen und den Figuren erläutert. Dabei zeigt
- Figur 1: ein erläuterndes Beispiel einer Siebdruckvorrichtung mit einem erläuternden Beispiel einer Druckform zum Flachbett-Siebdruck;
- Figur 2: eine zweite Ausführungsform einer Siebdruckvorrichtung mit einem Ausführungsbeispiel einer erfindungsgemäßen Druckform zum Rotationssiebdruck;
- Figur 3: eine Schnittdarstellung des erläuternden Beispiels einer Druckform der Siebdruckvorrichtung gemäß Figur 1;
- Figur 4: eine Draufsicht von oben auf die Druckform gemäß Figur 3.

Die Figuren zeigen schematische, nicht maßstabsgetreue Darstellungen. Gleiche Bezugszeichen in den Figuren bezeichnen gleiche oder gleichwirkende Elemente.

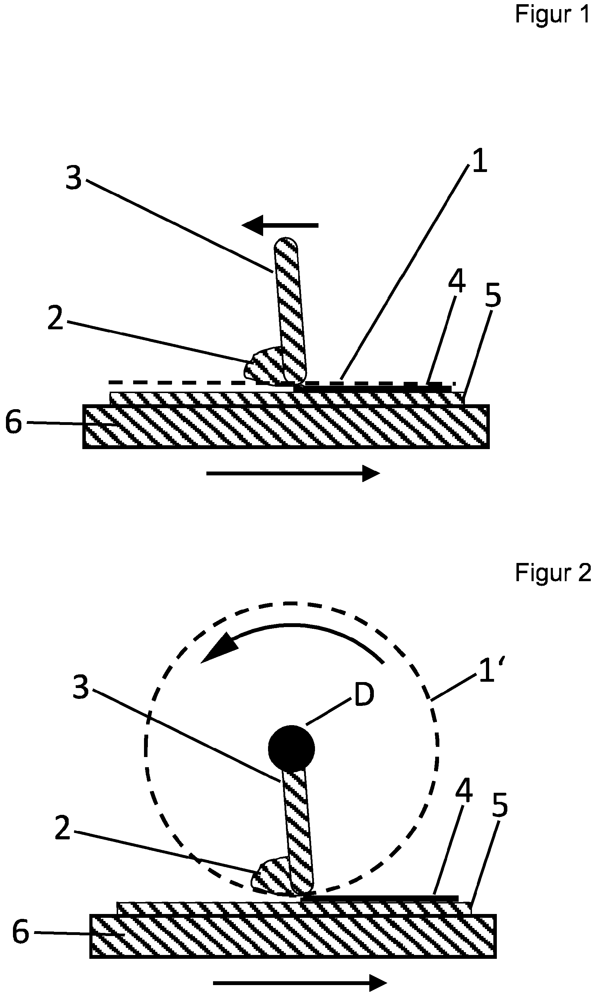

In Figur 1 ist ein erläuterndes Beispiel einer Siebdruckvorrichtung in Seitenansicht dargestellt. Die Vorrichtung ist zum Durchführen eines Flachbett-Siebdruckverfahrens ausgebildet.

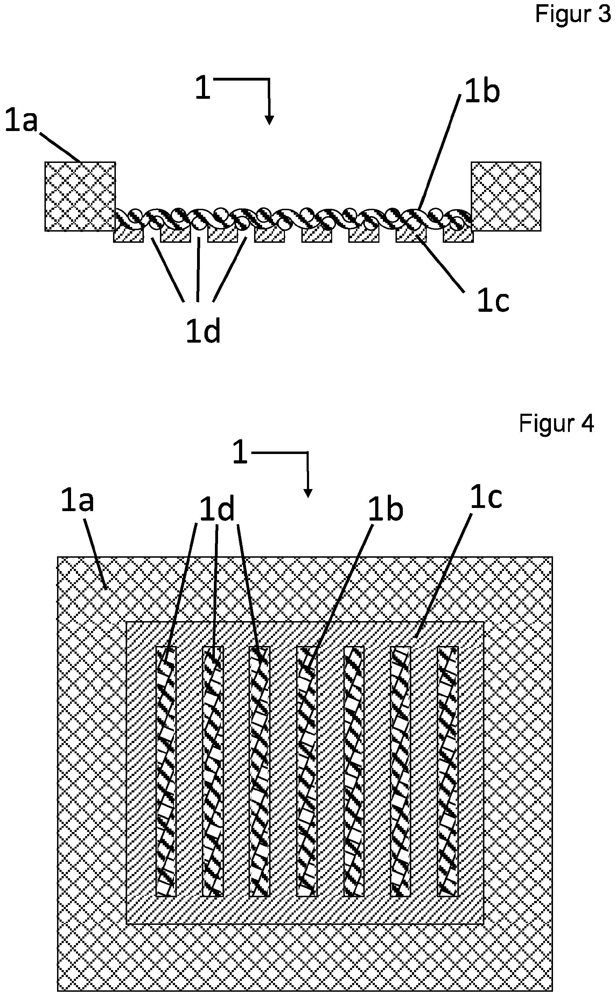

Die Vorrichtung weist ein als Siebdruckform 1 ausgebildetes erläuterndes Beispiel einer Druckform auf, welche als Flachbett-Siebdruckform ausgebildet ist. Die Siebdruckform 1 ist teilweise für eine Siebdruckpaste 2 durchlässig und teilweise für die Siebdruckpaste 2 undurchlässig ausgebildet, um eine vorgegebene Struktur auszubilden. Dies wird nachfolgend anhand der Figuren 3 und 4 näher erläutert.

Bei der Druckpaste 2 handelt es sich vorliegend um eine Metallpartikel enthaltende Druckpaste, welche dazu dient, nach thermischer Behandlung eine metallische Kontaktierungsstruktur in Form eines an sich bekannten Kontaktierungsgitters auf der Vorderseite eines als photovoltaische Solarzelle ausgebildeten elektronischen Bauelementes auszubilden.

Die Vorrichtung weist eine Rakel 3 auf, welche entlang der durch den über der Rakel abgebildeten Pfeil angegebenen Richtung mittels nicht dargestellter motorischer Mittel bewegt werden kann. Hierdurch wird die Siebdruckpaste 2 über die Siebdruckform 1 gestrichen und durchdringt die Siebdruckform 1 an den durchlässigen Stellen, sodass die Struktur 4 aus Siebdruckpaste auf einem Substrat 5 aufgebracht wird.

Das Substrat 5 ist vorliegend als Siliziumwafer ausgebildet, welcher bereits p- und n-dotierte Bereiche zum Ausbilden von Emitter und Basis aufweist. Das Substrat 5 stellt somit einen Solarzellen-Precursor dar, zur Fertigstellung der Solarzelle bedarf es weiterhin des Anordnens der metallischen Kontaktierungsstruktur auf der Vorderseite des Halbleitersubstrates 5.

Die Vorrichtung weist eine Zuführeinheit zum Zu- und Abführen von Halbleitersubstraten auf, welche ein (nicht dargestelltes) Förderband aufweist, auf dem mehrere Shuttles angeordnet sind. Beispielhaft ist in Figur 1 ein Shuttle 6 mit darauf liegendem Substrat 5 dargestellt.

In Figur 2 ist als alternative Ausführungsform eine zweite einer Druckvorrichtung mit einem als Siebdruckform 1' ausgebildeten Ausführunsgsbeispiel einer erfindungsgemäßen Druckform dargestellt. Diese Druckvorrichtung ist zur Durchführung eines Rotationssiebdruckverfahrens ausgebildet. Wie ein Vergleich der Figuren 1 und 2 zeigt, sind einige Elemente identisch ausgebildet und angeordnet. Wesentlich ist jedoch, dass bei dem zweiten Ausführungsbeispiel gemäß Figur 2 die Siebdruckform 1' als Rundsieb mit einer zylindrischen Form ausgebildet ist. Die Rakel 3 ist im Inneren der zylindrisch ausgebildeten Siebdruckform 1' angeordnet, sodass die Druckpaste 2 aus dem Inneren der Siebdruckform 1' durch die Siebdruckform hindurch nach außen gedrückt wird, um die Struktur 4 aus Druckpaste auf dem Substrat 5 auszubilden.

Hierzu weist die als Rundsieb ausgebildete Siebdruckform 1' eine Drehachse 1a auf und ist mittels motorischer Mittel in der durch den Kreisbogenpfeil gekennzeichneten Richtung drehbar. Die Drehachse 1a steht somit in Figur 2 senkrecht zur Zeichenebene.

Gleichzeitig wird mittels des Shuttles 6 das Halbleitersubstrat 5 in der als geradliniger Pfeil dargestellten Richtung bewegt, derart, dass die Relativgeschwindigkeit zwischen Substrat 5 und Mantelfläche der Siebdruckform 1' am Berührungspunkt zwischen Siebdruckform 1' und Substrat 5 Null oder zumindest vernachlässigbar gering ist.

Die Rakel 3 führt hingegen keine Drehbewegung durch, sodass die Druckpaste 2 im Inneren der Siebdruckform 1' aufgrund der Drehbewegung der Siebdruckform 1' gegen die Rakel 3 gedrückt wird und mittels der Rakel durch die Siebdruckform hindurch auf das Substrat 5 aufgebracht wird.

Die Siebdruckformen 1 und 1' sind grundsätzlich gleich aufgebaut, lediglich weist die Siebdruckform 1 eine ebene, rechteckige Form auf, wohingegen die Form der Siebdruckform 1' der Mantelfläche eines Zylinders entspricht.

Die Siebdruckform 1' stellt somit ein Ausführungsbeispiel einer erfindungsgemäßen Druckform dar, welche einen Siebrahmen aufweist, in welchem ein als Siebdruckgewebe ausgebildetes flächenförmiges Textil als Sieb unter Zugspannung angeordnet ist. Im Fall der Siebdruckform gemäß Figur 1 ist der Siebrahmen und auch das Sieb rechteckig ausgebildet. Im Fall der Siebdruckform gemäß Figur 2 ist das Sieb als Mantelfläche eines Zylinders ausgebildet. Der Siebrahmen weist ringförmige Elemente auf, welche an den beiden Kanten des mantelflächenförmigen Siebs angeordnet sind. Das Gewebe wird bevorzugt auf die ringförmigen Elemente geklebt. Bei der Siebdruckform gemäß Figur 1 wird die Zugspannung im Wesentlichen durch Einspannen des Siebs in den Siebrahmen ausgebildet. Bei der Siebdruckform gemäß Figur 2 wird die Zugspannung im Wesentlichen durch Fixieren des Siebdruckgewebes durch die Schablone ausgebildet. In einer alternativen Ausgestaltung sind zusätzlich Stege zwischen den ringförmigen Elementen vorgesehen, so dass die Zugspannung durch Einspannen des Siebs erzielt wird.

Bei beiden Siebdruckformen sind mittels einer Schablone eine Mehrzahl von länglichen, geradlinigen, vorliegend rechteckigen Öffnungen ausgebildet, sodass diese Öffnung einen für Druckpaste durchlässigen Druckbereich ausbilden, wohingegen die Schablone selbst einen für die Druckpaste undurchlässigen Sperrbereich ausbildet.

In Figur 3 ist ein Querschnitt durch die Siebdruckform 1 der Vorrichtung gemäß Figur 1 dargestellt. Die Siebdruckform 1 weist den rechteckigen Rahmen 1a auf, in welchem das als Siebdruckgewebe 1b ausgebildete flächenförmige Textil gespannt ist. Das Siebdruckgewebe 1b weist eine Vielzahl von als Gewebeelemente ausgebildete längliche Siebelemente auf, die in einer ersten Elementrichtung und einer senkrecht stehenden Elementrichtung angeordnet sind. Die erste Elementrichtung steht gemäß Figur 3 senkrecht zur Zeichenebene und entsprechend liegt die zweite Elementrichtung gemäß der Darstellung in Figur 3 parallel zur Zeichenebene.

An dem Siebdruckgewebe 1b ist die Schablone 1c angeordnet, welche in an sich bekannter Weise als Emulsion ausgebildet ist. Die Schablone 1c weist eine Vielzahl von Öffnungen auf, die jeweils als geradliniger, länglicher Kanal 1d ausgebildet sind. Die Kanäle der Siebdruckform 1 verlaufen parallel zueinander und senkrecht zur Zeichenebene gemäß Figur 3 und weisen vorliegend identische Breiten auf. Exemplarisch sind in Figur 3 drei Kanäle 1d gekennzeichnet.

Wird nun in Figur 3 von oben mittels der Rakel Siebdruckpaste auf die Siebdruckform 1 gedrückt, so kann die Siebdruckpaste die Siebdruckform nur im Bereich der Kanäle 1d durchdringen, sodass entsprechend der Positivform der Kanäle eine Struktur aus Siebdruckpaste auf einem unter der Figur 3 liegenden Substrat erzeugt wird, welche aus einer entsprechenden Vielzahl parallel nebeneinander angeordneter Linien aus Siebdruckpaste besteht.

In Figur 4 ist eine Rückansicht von unten auf die Siebdruckform 1 gemäß Figur 3 gezeigt. Schematisch ist dargestellt, dass im Bereich der Öffnungen der Schablone 1c, das heißt im Bereich der Kanäle 1d, die Siebdruckform nicht vollständig geöffnet ist, da unterhalb der Kanäle 1d Gewebeelemente des Siebdruckgewebes 1b verlaufen.

Im Fall der in Figur 1 dargestellten Druckform sind die länglichen Siebelemente aus Glasfaser ausgebildet mit einem Faserdurchmesser von 5 µm und einer Faserdichte von 59055 Drähten pro m (1500 Drähten pro Inch). Die Zugspannung beträgt 4000 N/mm² (Megapascal). In einer alternativen Ausgestaltung dieses Ausführungsbeispiels sind die länglichen Siebelemente aus Kohlenstofffasern ausgebildet mit den zuvor genannten Parametern.

Die Druckform gemäß Figur 2 weist längliche Siebelemente auf, welche aus Kohlenstoffnanoröhren ausgebildet sind. Der Durchmesser der Siebelemente beträgt 0,5 µm bei einer Faserdichte von 196850 pro m (5000 Siebelemente pro Inch). Die Siebelemente sind mit einer Zugspannung von 40.000 N/mm² (Megapascal) an dem Siebrahmen angeordnet.

Hierdurch ergibt sich der Vorteil, dass geringe Kanalbreiten realisiert werden können. Vorliegend beträgt die Kanalbreite bei dem erläuternden Beispiel 10 µm und bei dem Ausführungsbeispiel 5 µm.

## Patentansprüche

1. Druckform zur Herstellung einer Struktur (4) eines elektronischen Bauelementes, aufweisend einen Siebrahmen und ein als flächenförmiges Textil ausgebildetes Sieb mit einer Vielzahl von länglichen Siebelementen, wobei das Sieb in dem Siebrahmen angeordnet ist und das Sieb zumindest einen für eine Druckpaste durchlässigen Druckbereich und zumindest einen für die Druckpaste undurchlässigen Sperrbereich aufweist,
**dadurch gekennzeichnet,**
**dass** die länglichen Siebelemente als Kohlenstoffnanoröhre mit einem Durchmesser von 50 nm bis 2 µm ausgebildet sind und dass das Textil mit einer Zugspannung im Bereich von 6001 N/mm² (Megapascal) bis 63000 N/mm² (Megapascal) in dem Siebrahmen angeordnet ist.

2. Druckform nach einem der vorangegangenen Ansprüche,
**dadurch gekennzeichnet,**
**dass** der Siebrahmen einen Fügebereich aufweist, der dazu ausgestaltet ist, das gespannte Textil im Randbereich zumindest teilweise mit dem Siebrahmen stoffschlüssig zu verbinden.

3. Druckform nach einem der vorangegangenen Ansprüche,
**dadurch gekennzeichnet, dass**
der Druckbereich zumindest teilweise als eine längliche Kanalöffnung mit einer Längsachse und einer Kanalbreite (*w*) ausgestaltet ist, wobei die Kanalbreite (*w*) geringer ist als 40 µm.

4. Druckform nach Anspruch 3,
**dadurch gekennzeichnet, dass**
zumindest ein Siebelement in einem Winkel ungleich 0° gegenüber der Längsachse der Kanalöffnung angeordnet ist.

5. Druckform nach einem der vorangegangenen Ansprüche,
**dadurch gekennzeichnet,**
**dass** in dem Druckbereich ein Flächenverhältnis SUI, welches sich aus dem Verhältnis der freien Fläche im Druckbereich zu der von den länglichen Siebelementen im Druckbereich abgedeckten Fläche ergibt, größer als 0,5 ist.

6. Druckform nach einem der vorangegangenen Ansprüche,
**dadurch gekennzeichnet,**
**dass** die länglichen Siebelemente paarweise parallel oder senkrecht zueinander angeordnet sind.

7. Verfahren zur Herstellung einer Druckform mit einem Siebrahmen und einem flächigen Sieb mit einer Vielzahl von länglichen Siebelementen und zumindest einem für Druckpaste (2) durchlässigen Druckbereich und einen für Druckpaste (2) undurchlässigen Sperrbereich,
**dadurch gekennzeichnet,**
**dass** die länglichen Siebelemente in Form von Kohlenstoffnanoröhren mit einem Durchmesser von 50 nm bis 2 µm, in einem Bindungsschritt zu einem biegeschlaffen flächigen Textil, insbesondere einem Gewebe oder Gelege, gefügt werden,
wobei das flächige Textil in einem Spannschritt mit dem Randbereich an dem Siebrahmen angeordnet und mit dem Siebrahmen verbunden wird, dass das Textil mit einer Zugspannung im Bereich von 6001 N/mm² (Megapascal) bis 63000 N/mm² (Megapascal) in dem Siebrahmen angeordnet wird.

8. Verfahren nach Anspruch 7,
**dadurch gekennzeichnet,**
**dass** in einem Beschichtungsschritt eine für Druckpaste undurchlässige Sperrschicht an dem Sieb angeordnet wird und
in einem Strukturierungsschritt in der Sperrschicht eine längliche Kanalöffnung ausgestaltet wird, um einen für Druckpaste (2) durchlässigen Druckbereich auszubilden.

9. Verfahren nach Anspruch 8,
**dadurch gekennzeichnet,**
**dass** die Kanalöffnung eine Längsachse und eine Kanalbreite aufweist und die Kanalbreite kleiner 40 µm ist ist.

10. Verfahren nach Anspruch 9,
**dadurch gekennzeichnet,**
**dass** in einem Trennschritt ein Schablonenrohling, insbesondere ein dünnwandiges Blech, mittels eines Lasers zu einer Druckschablone (1c) verarbeitet wird, wobei im Schablonenrohling eine längliche Kanalöffnung ausgestaltet wird,
in einem Montageschritt die Druckschablone (1c) im Druckbereich des Siebs angeordnet wird.

11. Verfahren zum Aufbringen einer Druckpaste (2) auf die Oberfläche eines elektronischen Bauelementes, insbesondere einer photovoltaischen Solarzelle, mittels einer Druckform, wobei mittels einer Rakel (3) Druckpaste (2) durch die Druckform auf ein Substrat (5) des elektronischen Bauelements aufgebracht wird,
**dadurch gekennzeichnet,**
**dass** eine Druckform gemäß einem der Ansprüche 1 bis 6 verwendet wird.

## Claims

1. Printing stencil for producing a structure (4) of an electronic structural element, having a sieve frame and a sieve which is in the form of a sheet-like textile having a large number of elongate sieve elements, wherein the sieve is arranged in the sieve frame and the sieve has at least one pressure region which is permeable for a printing paste and at least one barrier region which is impermeable for the printing paste,
**characterized in that**
the elongate sieve elements are in the form of carbon nanotubes having a diameter of from 50 nm to 2 µm and **in that** the textile having a tensile stress in the range from 6001 N/mm² (Megapascal) to 63,000 N/mm² (Megapascal) is arranged in the sieve frame.

2. Printing stencil according to any one of the preceding claims,
**characterized in that**
the sieve frame has a joint region which is configured to at least partially connect the tensioned textile in the edge region to the sieve frame in a materially engaging manner.

3. Printing stencil according to any one of the preceding claims,
**characterized in that**
the printing region is at least partially in the form of an elongate channel opening having a longitudinal axis and a channel width (w), wherein the channel width (w) is less than 40 µm.

4. Printing stencil according to claim 3,
**characterized in that**
at least one sieve element is arranged at an angle not equal to 0° with respect to the longitudinal axis of the channel opening.

5. Printing stencil according to any one of the preceding claims,
**characterized in that**
in the printing region a surface ratio SUI which is produced from the ratio of the free surface-area in the printing region to the surface-area covered by the elongate sieve elements in the printing region is greater than 0.5.

6. Printing stencil according to any one of the preceding claims,
**characterized in that**
the elongate sieve elements are arranged in pairs parallel with or perpendicular to each other.

7. Method for producing a printing stencil having a sieve frame and a planar sieve having a large number of elongate sieve elements and at least one printing region which is permeable for printing paste (2) and a barrier region which is non-permeable for printing paste (2),
**characterized in that**
the elongate sieve elements in the form of carbon nanotubes having a diameter of from 50 nm to 2 µm are joined in a binding step to form a flexible planar textile, in particular a woven fabric or a web,
wherein the planar textile in a clamping step is arranged with the edge region on the sieve frame and is connected to the sieve frame, **in that** the textile with a tensile stress in the range from 6001 N/mm² (Megapascal) to 63,000 N/mm² (Megapascal) is arranged in the sieve frame.

8. Method according to claim 7,
**characterized in that**
in a coating step a barrier layer which is non-permeable for printing paste is arranged on the sieve and
in a structuring step an elongate channel opening is configured in the barrier layer in order to form a printing region which is permeable for printing paste (2).

9. Method according to claim 8,
**characterized in that**
the channel opening has a longitudinal axis and a channel width and the channel width is less than 40 µm.

10. Method according to claim 9,
**characterized in that**
in a separation step a template blank, in particular a thin-walled metal sheet, is processed by means of a laser to form a printing template (1c), wherein an elongate channel opening is formed in the template blank,
in an assembly step the printing template (1c) is arranged in the printing region of the sieve.

11. Method for applying a printing paste (2) to the surface of an electronic structural element, in particular a photovoltaic solar cell, by means of a printing stencil, wherein by means of a doctor blade (3) printing paste (2) is applied by the printing stencil to a substrate (5) of the electronic structural element,
**characterized in that**
a printing stencil according to any one of claims 1 to 6 is used.

## Revendications

1. Forme imprimante pour la fabrication d'une structure (4) d'un composant électronique, présentant un cadre de sérigraphie et un écran formé comme textile de forme plane avec une pluralité d'éléments de sérigraphie oblongs, dans laquelle l'écran est agencé dans le cadre de sérigraphie et l'écran présente au moins une zone d'impression perméable à une pâte d'impression et au moins une zone de blocage imperméable à la pâte d'impression,
**caractérisée en ce**
**que** les éléments de sérigraphie oblongs sont formés comme nanotubes de carbone avec un diamètre de 50 nm à 2 µm et en ce que le textile avec une contrainte de traction dans la plage de 6 001 N/mm² (mégapascal) à 63 000 N/mm² (mégapascal) est agencé dans le cadre de sérigraphie.

2. Forme imprimante selon l'une quelconque des revendications précédentes,
**caractérisée en ce**
**que** le cadre de sérigraphie présente une zone d'assemblage qui est configurée afin de relier par matière le textile tendu dans la zone de bord au moins partiellement au cadre de sérigraphie.

3. Forme imprimante selon l'une quelconque des revendications précédentes,
**caractérisée en ce que**
la zone d'impression est configurée au moins partiellement comme une ouverture de canal oblongue avec un axe longitudinal et une largeur de canal *(w),* dans laquelle la largeur de canal *(w)* est inférieure à 40 µm.

4. Forme imprimante selon la revendication 3,
**caractérisée en ce**
**qu'**au moins un élément de sérigraphie est agencé selon un angle inégal à 0° par rapport à l'axe longitudinal de l'ouverture de canal.

5. Forme imprimante selon l'une quelconque des revendications précédentes,
**caractérisée en ce**
**qu'**un rapport de surface SUI qui résulte du rapport entre la surface libre dans la zone d'impression et la surface recouverte par les éléments de sérigraphie oblongs dans la zone d'impression, est supérieur à 0,5 dans la zone d'impression.

6. Forme imprimante selon l'une quelconque des revendications précédentes,
**caractérisée en ce**
**que** les éléments de sérigraphie oblongs sont agencés par paires parallèlement ou perpendiculairement les uns aux autres.

7. Procédé de fabrication d'une forme imprimante avec un cadre de sérigraphie et un écran plan avec une pluralité d'éléments de sérigraphie oblongs et au moins une zone d'impression perméable à la pâte d'impression (2) et une zone de blocage imperméable à la pâte d'impression (2),
**caractérisée en ce**
**que** les éléments de sérigraphie oblongs sont assemblés sous la forme de nanotubes de carbone avec un diamètre de 50 nm à 2 µm, dans une étape de liaison en un textile plan souple en flexion, en particulier un tissu ou nappe,
dans lequel le textile plan est agencé dans une étape de tension avec la zone de bord au niveau du cadre de sérigraphie et est relié au cadre de sérigraphie, en ce que le textile est agencé avec une contrainte de traction dans la plage de 6 001 N/mm² (mégapascal) à 63 000 N/mm² (mégapascal) dans le cadre de sérigraphie.

8. Procédé selon la revendication 7,
**caractérisée en ce**
**qu'**une couche de blocage imperméable à la pâte d'impression est agencée au niveau de l'écran dans une étape de revêtement et
une ouverture de canal oblongue est configurée dans une étape de structuration dans la couche de blocage afin de former une zone d'impression perméable à la pâte d'impression (2).

9. Procédé selon la revendication 8,
**caractérisée en ce**
**que** l'ouverture de canal présente un axe longitudinal et une largeur de canal et la largeur de canal est inférieure à 40 µm.

10. Procédé selon la revendication 9,
**caractérisée en ce**
**que** dans une étape de séparation, une ébauche de gabarit, en particulier une tôle à paroi mince, est traitée au moyen d'un laser pour former un gabarit d'impression (1c), dans lequel une ouverture de canal oblongue est configurée dans l'ébauche de gabarit,
le gabarit d'impression (1c) est agencé dans la zone d'impression de l'écran dans une étape de montage.

11. Procédé d'application d'une pâte d'impression (2) sur la surface d'un composant électronique, en particulier d'une cellule solaire photovoltaïque, au moyen d'une forme imprimante, dans lequel de la pâte d'impression (2) est appliquée au moyen d'une racle (3) par la forme imprimante sur un substrat (5) du composant électronique,
**caractérisée en ce**
**qu'**une forme imprimante selon l'une quelconque des revendications 1 à 6 est utilisée.
